# FASCICULE DE BREVET EUROPEEN

(11) **EP 1 019 962 B1**
(45) Date de publication et mention de la délivrance du brevet: **24.11.2004**
(21) Numéro de dépôt: 98945359.2
(22) Date de dépôt: 22.09.1998
(51) Int. Cl.: H01L 23/66, H01L 23/498

(54) **PROCEDE D'ENROBAGE D'UNE PUCE ELECTRONIQUE ET CARTE ELECTRONIQUE COMPORTANT AU MOINS UN PUCE ENROBEE SELON CE PROCEDE**
VERKAPSELUNGSVERFAHREN EINES ELEKTRONISCHEN CHIPS UND ELEKTRONISCHE KARTE MIT WENIGSTENS EINEM MITTELS DIESES VERFAHRENS VERKAPSELTEN CHIP
METHOD FOR ENCAPSULATING A SILICON CHIP AND ELECTRONIC CARD COMPRISING AT LEAST ONE CHIP COATED BY SUCH METHOD

(30) Priorité: 30.09.1997 FR 9712131
(43) Date de publication de la demande: 19.07.2000
(73) Titulaire: Thales, 75008 Paris (FR)
(72) Inventeur: CACHIER, Gérard Thomson-CSF Propriété Intellectue, F94117 Arcueil Cedex (FR); DADEN, Jean-Yves Thomson-CSF Propriété Intellect., F-94117 Arcueil Cedex (FR); GRANCHER, Alain Thomson-CSF Propriété Intellect., F-94117 Arcueil Cedex (FR); MICHEL, Ludovic Thomson-CSF Propriété Intellect., F-94117 Arcueil Cedex (FR)
(74) Mandataire: Chaverneff, Vladimir
(86) Numéro de dépôt international: PCT/FR1998/002035
(87) Numéro de publication internationale: WO 1999/017367

(56) Documents cités:
- EP-A- 0 249 378
- EP-A- 0 387 955
- FR-A- 2 337 381
- FR-A- 2 348 574

## Description

La présente invention concerne la protection des puces électroniques, chips dans la littérature anglo-saxonne, en particulier dans le cadre de leur utilisation en hyperfréquences.

Il est connu de réaliser des cartes électroniques comportant un support ou semelle, une fiche de raccordement et au moins une puce avec ses circuits de raccordement. Le support est une plaque plane, généralement en laiton, sur laquelle sont disposées la puce et une partie en circuit imprimé qui comporte les circuits de raccordement de la puce ; cette partie en circuit imprimé est connectée à la puce par des liaisons filaires.

Pour assurer la protection mécanique d'une puce ainsi montée dans une carte électronique il est connu de l'enrober dans un produit tel qu'une résine. Pour cela de la résine est déposée sur la puce et ses liaisons filaires avec les circuits de raccordement; après durcissement la résine constitue une sorte de carapace qui protège efficacement la puce et ses liaisons filaires.

Mais ces puces sont conçues pour fonctionner avec propagation radioélectrique dans un milieu hétérogène qui est, par exemple, l'air et l'Asga ; or la résine transforme ce milieu en un milieu air, résine, Asga et il en résulte une modification de la propagation et donc du comportement électrique de la puce. Cette modification est d'autant moins acceptable que les fréquences de travail sont plus élevées et, en pratique, le procédé d'enrobage indiqué ci-avant ne permet que des fonctionnements à des fréquences inférieures à 10 GHz.

La présente invention a pour but de proposer un procédé d'enrobage qui permet des fonctionnements pouvant aller jusqu'à 50 GHz.

Ceci est obtenu par une maîtrise de la quantité de résine déposée, afin de réduire l'épaisseur de cette dernière à une fine couche et donc de réduire, par là même, les effets perturbateurs.

Selon l'invention, il est proposé un procédé d'enrobage d'une puce électronique, la puce étant disposée sur un support mécanique comportant une face plane, une partie en circuit imprimé d'épaisseur supérieure à l'épaisseur de la puce est disposée sur le support et entoure au moins partiellement la puce, le support comportant un bossage en saillie de la surface plane caractérisé en ce qu'il consiste à :
- surélever la puce en la disposant sur le bossage,
- choisir une épaisseur de bossage telle que :
   - la hauteur des faces des supérieures des circuits imprimés considérée au-dessus de la face du support soit supérieure à la hauteur de la face supérieure de la puce au-dessus de la face F1 du support, et
   - la différence entre ces deux hauteurs soit inférieure à une valeur prédéterminée,
- remplir avec un produit d'enrobage l'espace entre la partie en circuit imprimé et la puce jusqu'au niveau supérieur de la partie en circuit imprimé.
- faire durcir le produit d'enrobage.

Selon l'invention, il est également proposé une carte électronique comportant au moins une puce électronique, caractérisée en ce que la puce est protégée par un enrobage réalisé selon un procédé d'enrobage décrit dans le paragraphe précédent.

La présente invention sera mieux comprise et d'autres caractéristiques apparaîtront à l'aide de la description ci-après et des figures s'y rapportant qui représentent :
- la figure 1 une vue partielle en coupe d'un élément de carte électronique utilisé dans une mise en oeuvre du procédé selon l'invention
- les figures 2a, 2b, des vues partielles de dessus et en coupe d'une carte électronique dont la conception constitue une étape du procédé selon l'invention,
- les figures 3a, 3b, des vues correspondant à celles des figures 2a, 2b mais lors de la phase d'enrobage proprement dit, telle que proposée dans le procédé selon l'invention,
- la figure 4, une variante, dans le cadre de l'invention, à la réalisation de l'élément selon la figure 1,
- la figure 5, une variante, dans le cadre de l'invention, à la réalisation de la carte électronique des figures 2a, 2b.

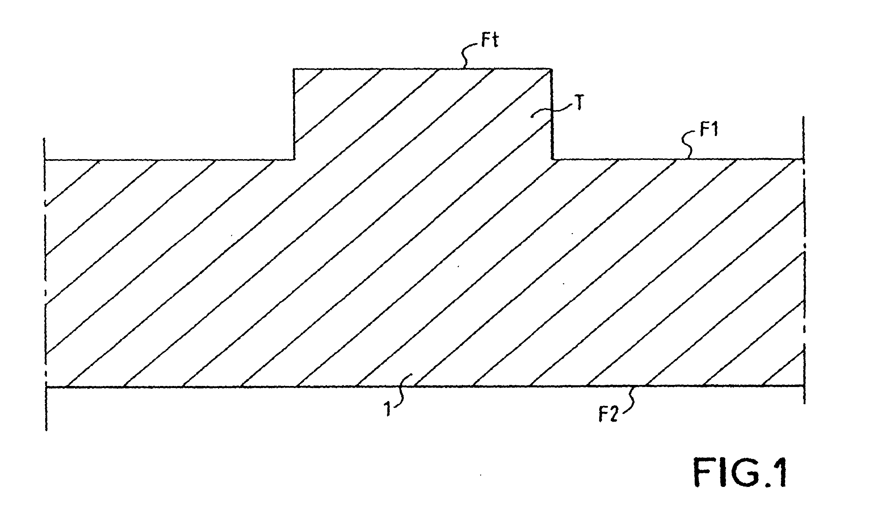

La figure 1 représente, en vue partielle limitée entre deux traits d'axe, une plaque en laiton, 1, à deux faces planes parallèles F1, F2. L'une, F1, de ces faces présente un bossage ou tab, T, qui constitue un parallélogramme dont la face supérieure, Ft, est un rectangle parallèle aux faces F1, F2. La plaque est destinée à constituer le support mécanique, aussi appelé semelle, d'une carte électronique sur laquelle est montée une puce électronique. Le bossage est prévu pour la mise en oeuvre du procédé d'enrobage qui est décrit dans ce document et son rôle apparaîtra dans ce qui suit ; les semelles classiques ne comportent pas de bossages.

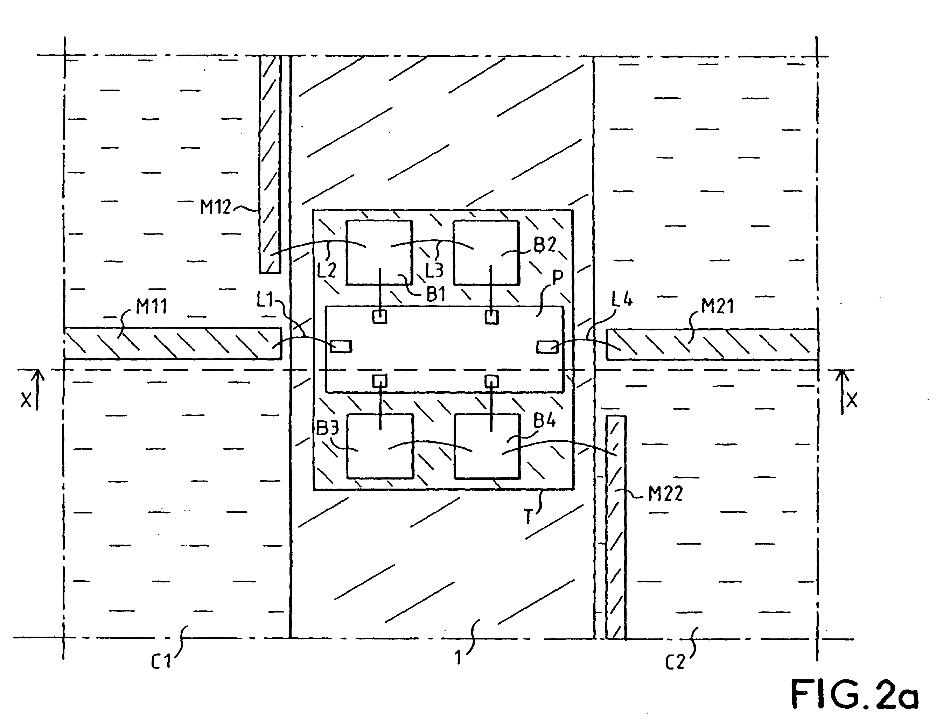

La figure 2a représente, en vue partielle de dessus, la semelle 1 de la figure 1 mais telle qu'elle se présente après que des composants aient été disposés par brasure sur celle, F1, de ses faces qui présente le bossage T ; la figure 2a est donc une vue partielle d'une carte électronique. Les composants visibles sur la figure 2a sont constitués de deux circuits imprimés C1, C2, d'une puce P avec ses éléments de découplage B1 à B4 et de conducteurs, tels que L1 à L4, qui assurent des liaisons entre les composants.

Les éléments de découplage B1 à B4 constituent des filtres passe-bas branchés sur les bornes d'alimentation de la puce. Ces éléments de découplage et la puce sont mises en place par brasure sur la face supérieure du bossage T et les dimensions de cette face supérieure correspondent à la surface juste nécessaire pour une mise en place aisée de la puce et des quatre éléments de découplage.

Les circuits imprimés C1, C2 portent, sur leur face supérieure, c'est-à-dire sur leur face opposée à la face F1 de la semelle 1, des circuits de raccordement faits de rubans conducteurs: M11, M12 pour le circuit imprimé C1 et M21, M22 pour le circuit imprimé C2; quant à leur face inférieure elle est entièrement constituée par un plan de masse en cuivre. Ces deux circuits imprimés sont disposés de part et d'autre et au voisinage immédiat du bossage T.

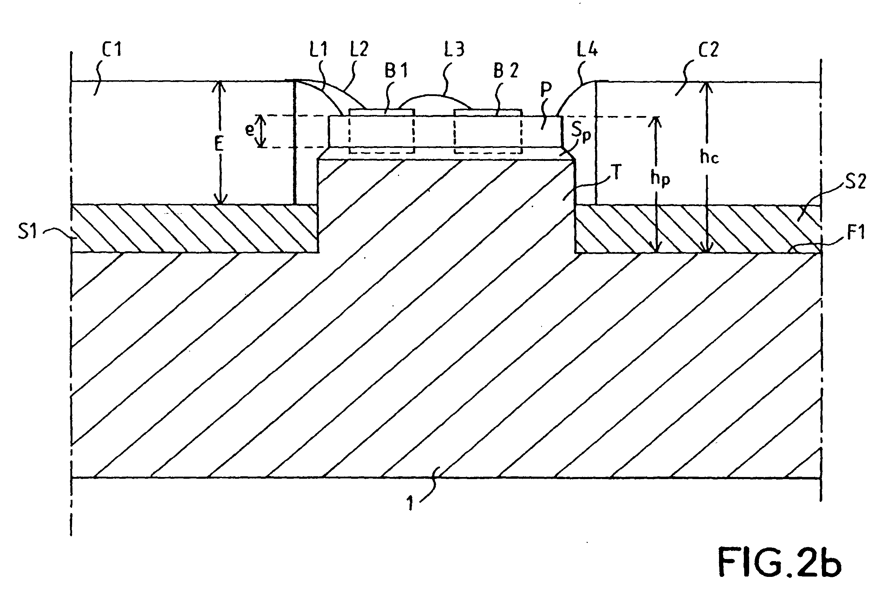

La figure 2b est une vue en coupe correspondant à la vue partielle de la carte électronique selon la figure 2a ; le plan de coupe est un plan perpendiculaire au plan de la figure 2a et la trace de ce plan de coupe dans la figure 2a a été repéré par une droite en traits interrompus XX ; c'est un plan de coupe semblable qui est utilisé pour les coupes des figures 1, 3b et 4. Sur cette vue en coupe apparaissent, outre la semelle 1, la puce P, les éléments de couplage B1, B2, les conducteurs L1 à L4 et les soudures S1, S2, Sp entre la semelle 1 et, respectivement, les circuits imprimés C1, C2 et l'ensemble constitué par la puce P et ses éléments de découplage.

Sur cette figure ont été notées :
- la hauteur hc, au-dessus de la face F1 de la semelle 1, des faces supérieures des circuits imprimés C1, C2,
- la hauteur hp, au-dessus de la face F1 de la semelle 1, de la face supérieure de la puce 1,
- les épaisseurs E des circuits imprimés et e de la puce.

Il est à noter sur la figure 2b que, grâce au bossage T, la valeur hc est légèrement supérieure à la valeur hc et que la différence hc-hp est notablement inférieure à une valeur prédéterminée qui sera explicitée dans ce qui suit.

Dans une disposition classique où la puce est soudée sur une semelle sans bossage, la résine n'est pas versée sur la puce en prenant pour repère de fin de remplissage le bord supérieur d'un circuit imprimé et ne peut être dosée avec précision; pour acquérir la certitude d'un enrobage correct il est nécessaire que la couche de résine au-dessus de la puce soit relativement épaisse, en particulier pour couvrir les conducteurs de liaison ; il en résulte, comme cela a été indiqué plus avant, une modification de la propagation radioélectrique telle, que les fréquences de fonctionnement, pour éviter les perturbations, doivent toujours être choisies en dessous de 10 GHz.

Au contraire dans une réalisation comme celle des figures 2a, 2b il est possible de maîtriser l'épaisseur de résine au-dessus de la puce 1 ; il suffit pour cela de choisir convenablement la valeur à donner à hc-hp, c'est-à-dire en fait la hauteur à donner au bossage T ; la résine à l'état fluide peut alors être versée sur la puce en utilisant comme repère pour le niveau supérieur, le bord supérieur des circuits imprimés.

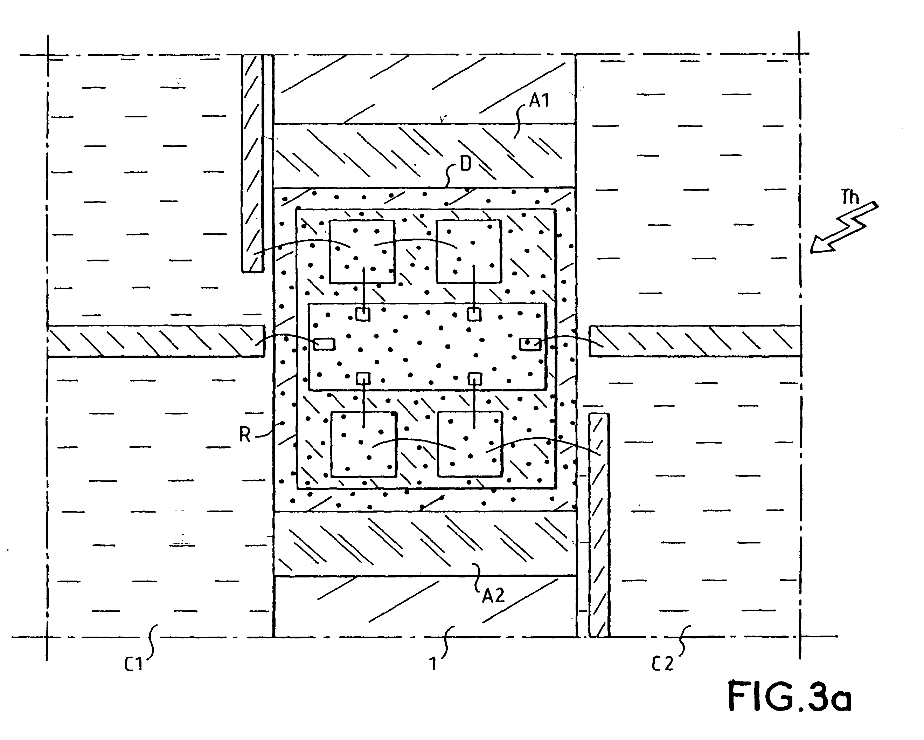

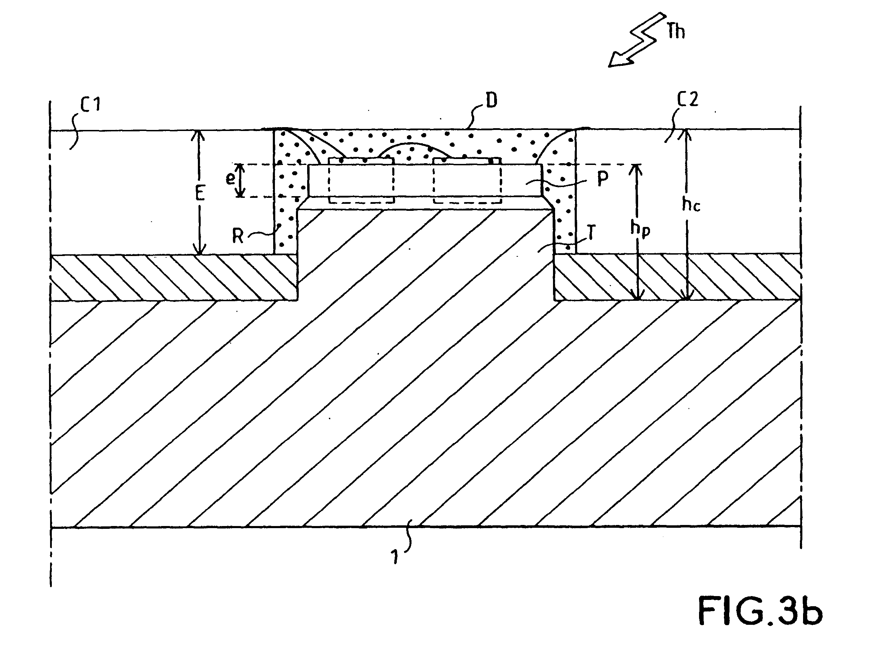

Les figures 3a et 3b illustrent un tel remplissage. Ces figures reprennent les figures 2a et 2b avec en plus la résine, R, représentée par des points noirs. Sous cette résine les constituants cachés, tels la puce, ont été représentés comme vus par transparence.

L'espace dans lequel est située la puce P n'est limité latéralement que sur deux côtés, grâce aux circuits imprimés C1, C2. Il est donc nécessaire, avant le remplissage avec la résine à l'état fluide, de fermer les deux autres côtés. Ceci est réalisé à l'aide d'un outil muni d'une sorte de pince à deux mors A1, A2 et cet outil se guide sur les bords de la plaque 1 et des circuits imprimés C1, C2 pour positionner ses mors ; la réalisation d'un tel outil ou d'un autre outil voire d'un montage capable de jouer le même rôle étant à la portée de l'homme du métier de la mécanique, afin de simplifier l'exposé et donc de le rendre plus clair, seuls les deux mors ont été représentés et ce, dans la position qu'ils occupent lors du remplissage et pendant le durcissement de la résine. Les mors A1 et A2 sont des plaques parallèles entre elles d'une longueur à peine inférieure à l'écart entre les deux circuits imprimés et d'une hauteur égale à l'épaisseur E des circuits imprimés. Le bord supérieur du mors A1 est repéré par la lettre D sur les figures 3a et 3b.

Par cette façon de régler le niveau de résine, il est loisible de prédéterminer avec précision l'épaisseur de la couche déposée sur une puce électronique en fonction des fréquences de travail à atteindre ; c'est ainsi que, dans les réalisations qui ont servi d'exemples à la présente description, il a été possible de limiter l'altération de transmission due à l'enrobage à moins de 0,7 décibels, à la fréquence de 40 GHz ; pour cela il est apparu que la valeur prédéterminée à ne pas dépasser pour hc-hp était de 100 micromètres.

Une bonne mise en oeuvre du procédé qui vient d'être décrit nécessite un usinage de la semelle et un contrôle des épaisseurs de brasure et de résine tels que les tolérances sur les cotes soient compatibles avec la valeur prédéterminée à ne pas dépasser. Elle nécessite également de choisir un produit d'enrobage, résine ou autre, qui ne se rétracte que très peu lors de sa solidification.

Cette solidification se fait, de façon classique, à haute température dans un four et est suivie du retrait de l'outil équipé des mors A1, A2 ; elle est figurée sur les figures 3a, 3b par une flèche marquée Th. Pour compenser, si besoin, un légère rétraction de la résine lors du passage au four, il est possible, en mettant à profit la viscosité de la résine avant durcissement, de doser l'apport de résine de manière que, sans déborder sur les circuits imprimés et les mors, il ait une surface légèrement bombée.

Le dosage de l'apport de résine peut se faire de différentes manières et en particulier : - à vue, - par goutte calibrée déposée sur la puce au moyen, par exemple, d'une seringue, - par application au pinceau, - par pochoir calibré avec une poche souple qui contient la résine et la laisse se déposer par pression, - par centrifugeuse : une rotation rapide de la carte électronique permet de ne garder la résine que sur la puce, - voire en utilisant, au lieu de l'outil à mors représenté sur les figures 3a, 3b, un outil à mors + couvercle afin de constituer un espace clos muni de deux orifices, l'un pour injecter la résine et l'autre pour jouer le rôle d'évent c'est-à-dire pour laisser échapper le surplus de résine injecté. Dans les réalisations qui ont servi d'exemple à la présente description la première puis la seconde manière ont été utilisées.

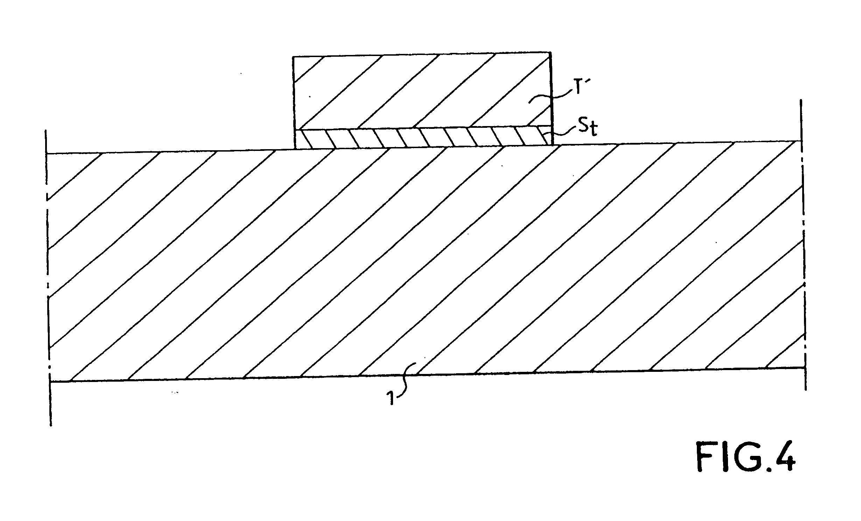

L'invention n'est pas limitée à la description qui précède; c'est ainsi en particulier que, au lieu de faire partie intégrante de la semelle, le bossage peut être une pièce métallique rapportée sur la plaque par brasure ou à l'aide d'une colle conductrice ; la figure 4 illustre une telle semelle avec une plaque 1 et, sur une des faces de cette plaque, une pièce T fixée par une brasure St.

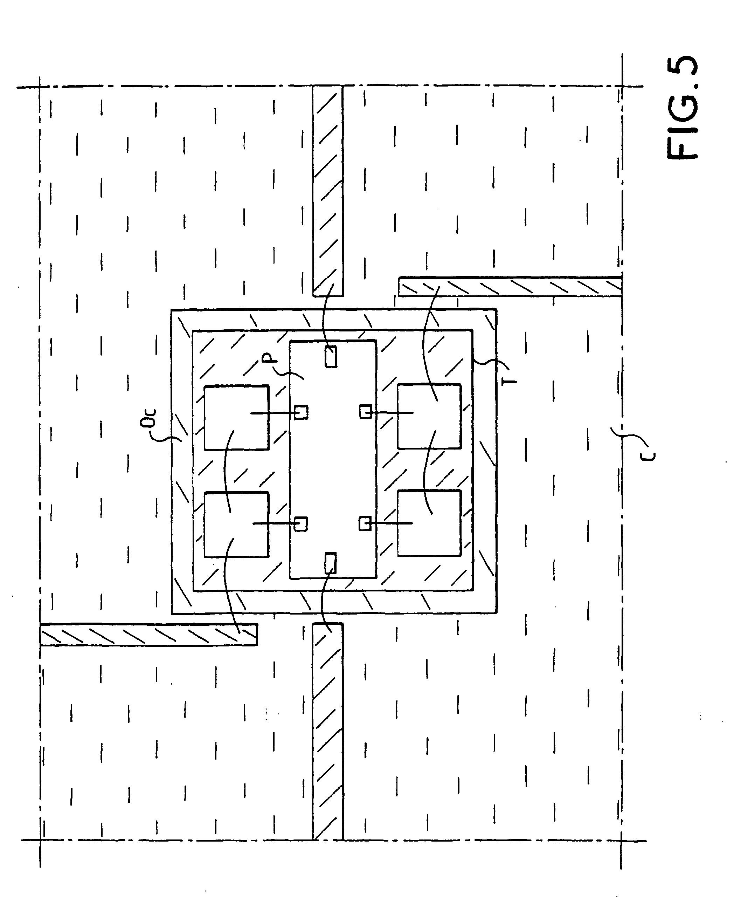

Une autre possibilité de mise en oeuvre du procédé passe par une conception de cartes électroniques dans lesquelles la partie en circuit imprimé entoure totalement la puce à enrober. Ceci peut être réalisé à l'aide de quatre circuits imprimés accolés pour ne laisser libre sur la semelle que la surface nécessaire au branchement de la puce. Ceci peut également être réalisé, comme illustré sur la figure 5, grâce à un seul circuit imprimé, C, percé d'un trou Oc dont l'emplacement et les dimensions sont déterminés en fonction du branchement de la puce P.

Il est à noter que les variantes de mise en oeuvre du procédé dont il est question au paragraphe précédent facilitent l'enrobage de la puce, par contre, pour des cartes déjà étudiées, elles vont au delà d'une simple modification de la semelle et d'un éventuel replacement de deux circuits imprimés, destiné à rapprocher ces circuits imprimés de la puce; ces variantes sont donc onéreuses si elles ne sont pas prévues dès la conception de la carte électronique.

## Revendications

1. Procédé d'enrobage d'une puce électronique, la puce (P) étant disposée sur un support mécanique comportant une face plane, une partie en circuit imprimé d'épaisseur supérieure à l'épaisseur de la puce est disposée sur le support et entoure au moins partiellement la puce, le support (1) comportant un bossage (T, T', St) en saillie de la face plane (F1), le procédé comportant les étapes suivantes :
• surélever la puce (P) en la disposant sur le bossage (T, T', St),
• choisir une épaisseur de bossage telle que :
• la hauteur (hc) des faces supérieures des circuits imprimés (C1, C2) considérée au-dessus de la face plane (F1) du support (1) soit supérieure à la hauteur (hp) de la face supérieure de la puce (P) au-dessus de la face plane F1 du support (1), et
• la différence entre ces deux hauteurs (hp), (hc) soit inférieure à une valeur prédéterminée,
• remplir avec un produit d'enrobage ( R) l'espace entre la partie en circuit imprimé et la puce,
• faire durcir le produit d'enrobage, remplir ledit espace, **caractérisé en ce que** l'espace est rempli jusqu'au niveau supérieur de la partie en circuit imprimé.

2. Procédé selon la revendication 1, mis en oeuvre dans le cas où la partie en circuit imprimé (C1, C2) n'entoure que partiellement la puce, **caractérisé en ce qu'**il consiste à compléter l'entourage de la puce au moyen de parois (A1 ,A2) à usage temporaire qui sont retirées après durcissement (Th) du produit d'enrobage.

3. Procédé selon la revendication 1, **caractérisé en ce que** la partie en circuit imprimé (C) entoure totalement la puce (P).

4. Procédé selon la revendication 3, **caractérisé en ce que** la partie en circuit imprimé comporte un circuit imprimé (C) percé d'un trou (Oc) dont les bords entourent la puce (P).

5. Procédé selon la revendication 1, **caractérisé en ce que** le bossage (T) fait partie intégrante de la plaque (1).

6. Procédé selon la revendication 1, **caractérisé en ce que** le bossage (T', St) est une pièce métallique rapportée sur la plaque (1).

7. Carte électronique comportant au moins une puce électronique, **caractérisée en ce que** la puce (P) est protégée par un enrobage réalisé selon un procédé d'enrobage décrit dans l'une au moins des revendications précédentes.

## Patentansprüche

1. Verkapselungsverfahren für einen elektronischen Chip, wobei der Chip (P) auf einem mechanischen Träger mit einer ebenen Fläche angeordnet wird, wobei ein gedruckter Schaltungsteil mit einer Dicke größer als die Dicke des Chips auf dem Träger angeordnet wird und den Chip zumindest teilweise umgibt, wobei der Träger (1) einen von der ebenen Fläche (F1) vorspringenden Höcker (T, T', St) umfasst, wobei das Verfahren die folgenden Schritte umfasst:
- Erhöhen des Chips (P), indem er auf dem Höcker (T, T', St) angeordnet wird,
- Auswählen einer Dicke des Höckers derart, dass:
- die betreffende Höhe (hc) der Oberseiten der gedruckten Schaltungen (C1, C2) über der ebenen Fläche (F1) des Trägers (1) größer als die Höhe (hp) der Oberseite des Chips (P) über der ebenen Fläche (F1) des Trägers (1) ist, und
- der Unterschied zwischen diesen zwei Höhen (hp), (hc) kleiner als ein vorbestimmter Wert ist,
- Anfüllen des Raums zwischen dem gedruckten Leitungsteil und dem Chip mit einem Verkapselungsprodukt (R),
- Aushärten des Verkapselungsprodukts,
- Anfüllen des Raums, **dadurch gekennzeichnet, dass** der Raum bis auf das obere Niveau des gedruckten Leitungsteils angefüllt wird.

2. Verfahren nach Anspruch 1, das in dem Fall eingesetzt wird, dass der gedruckte Leitungsteil (C1, C2) den Chip nur teilweise umgibt, dadurchgekennzeichnet, dass es darin besteht, das Umgeben des Chips mittels zeitweise genutzter Wände (A1, A2) zu komplettieren, die nach dem Aushärten (Th) des Verkapselungsprodukts zurückgezogen werden.

3. Verfahren nach Anspruch 1, **dadurch gekennzeichnet, dass** der gedruckte Leitungsteil (C) den Chip (P) ganz umgibt.

4. Verfahren nach Anspruch 3, **dadurch gekennzeichnet, dass** der gedruckte Leitungsteil eine gedruckte Schaltung (C) umfasst, die von einem Loch (Oc) durchbohrt wird, dessen Ränder den Chip (P) umgeben.

5. Verfahren nach Anspruch 1, **dadurch gekennzeichnet, dass** der Höcker (T) integraler Bestandteil der Platte (1) ist.

6. Verfahren nach Anspruch 1, **dadurch gekennzeichnet, dass** der Höcker (T', St) ein an der Platte (1) angebrachtes Metallteil ist.

7. Elektronische Karte mit zumindest einem elektronischen Chip, **dadurch gekennzeichnet, dass** der Chip (P) durch eine Verkapselung geschützt ist, die gemäß einem in zumindest einem der vorhergehenden Ansprüche beschriebenen Verkapselungsverfahren hergestellt ist.

## Claims

1. Process for encapsulating an electronic chip, the chip being placed on a mechanical support having a plane face, part of a printed circuit having a thickness greater than the thickness of the chip is placed on the support and at least partially surrounds the chip, the support (1) having a tab (T; T', St) that projects from the plane face (F1), the process comprising the following steps:
• raising the chip (P) by placing it on the tab (T, T', St);
• choosing a tab thickness such that:
• the height (hc) of the upper faces of the printed circuits (C1, C2) in question above the plane face (F1) of the support (1) is greater than the height (hp) of the upper face of the chip (P) above the plane face (F1) of the support (1) and
• the difference between these two heights (hp), (hc) is less than a predetermined value;
• filling the space between the printed-circuit part and the chip with an encapsulation product (R);
• curing the encapsulation product and filling the said space, **characterized in that** the space is filled as far as the upper level of the printed-circuit part.

2. Process according to Claim 1, used in the case in which the printed-circuit part (C1, C2) only partly surrounds the chip, **characterized in that** it consists in completing the surrounding of the chip by means of walls (A1, A2) for temporary use, which walls are removed after the encapsulation product has been cured (Th).

3. Process according to Claim 1, **characterized in that** the printed-circuit part (C) completely surrounds the chip (P).

4. Process according to Claim 3, **characterized in that** the printed-circuit part includes a printed circuit (C) pierced by a hole (Oc), the edges of which surround the chip (P).

5. Process according to Claim 1, **characterized in that** the tab (T) forms an integral part of the plate (1).

6. Process according to Claim 1, **characterized in that** the tab (T', St) is a metal piece attached to the plate (1).

7. Electronic card which includes at least one electronic chip **characterized in that** the chip (P) is protected by an encapsulation produced according to an encapsulation process described in at least one of the preceding claims.
